Europäisches Patentamt

European Patent Office

Office européen des brevets

(11) Veröffentlichung··~ ·mm··    **0 228 704**

**A2**

(12) # EUROPÄISCHE PATENTANMELDUNG

(21) Anmeldenummer: 86118062.8

(22) Anmeldetag: 24.12.86

(51) Int. Cl.4: **H 05 K 13/06**

(30) Priorität: 27.12.85 ES 291343 U

(43) Veröffentlichungstag der Anmeldung:
15.07.87 Patentblatt 87/29

(84) Benannte Vertragsstaaten:
AT BE CH DE FR GB IT LI LU NL SE

(71) Anmelder: **CIRCUITGRAPH, S.L.**
**4, Nunez Morgado Street**
**E-28036 Madrid(ES)**

(72) Erfinder: **Valenciano Melero, Pedro**
**27, Marqués de Lozoya Street**
**ES-28007 Madrid(ES)**

(74) Vertreter: **Gossel, Hans K., Dipl.-Ing. et al,**
**Rechtsanwälte E. Lorenz - B. Seidler M. Seidler - Dipl.-Ing.**
**H.K. Gossel Dr. I. Philipps - Dr. P.B. Schäuble Dr. S.**
**Jackermeier - Dipl.-Ing. A. Zinnecker**
**Widenmayerstrasse 23 D-8000 München 22(DE)**

(54) **Vorrichtung für die von Hand durchgeführte Verkabelung elektronischer Kreisläufe.**

(57) Eine Vorrichtung dient für von Hand durchgeführte Verkabelungen elektronischer Kreisläufe. Sie besteht aus einem länglichen Körper (1) mit einer Verteilerspitze (4), über die das axial durchlaufende Kabel (5) nach außen tritt. Ein Kabelmesser (17) ist längs einer Mantellinie des länglichen Körpers (1) verschieblich geführt und über Buchsen (22, 15) mit einer Feder (24) belastet. Um eine derartige Vorrichtung zu verbessern, ist die Buchse (22) mit zwei flexiblen, diametral gegenüberliegenden Platten (25) verbunden, die an ihren Enden jeweils als Schleifbacken (26) ausgebildet sind, zwischen denen das Kabel (5) durchläuft und deren Verschluß die Entfernung des Kabelüberzuges bewirkt. Die flexiblen Platten besitzen auf ihrer Außenseite Anschlagstifte (27), die in schraubenförmigen Rillen (28) auf der Innenseite des Körpers (1) laufen. Hierdurch wird eine Drehung der Schleifbacken (26) bewirkt, die die Wirkung auf den Kabelüberzug erhöht.

EP 0 228 704 A2

BESCHREIBUNG

Wie sich aus dem Titel dieser Beschreibung ergibt, bezieht sich die vorliegende Erfindung auf eine Vorrichtung, welche speziell für von Hand durchgeführte Verkabelungen elektronischer Kreisläufe gedacht ist und deren offensichtlicher Zweck darin besteht, bei derartigen Verkabelungsarbeiten die Zuführung des Leitungsdrahtes, die Spannung desselben zu seiner Straffung zwischen zwei zu verbindenden Punkten, die Fragmentierung des Kabels nach jedem Anschluss sowie das Schälen des Kabels an dessen Anschlussenden zu erleichtern, wenn es mit einem elektrisch isolierenden Überzug auf der Grundlage der klassischen Glasur versehen ist.

Genauer gesagt wurde die Vorrichtung speziell zur Durchführung des Verfahrens zur Herstellung elektronischer Kreisläufe nach dem Erfindungspatent 538.302 ausgelegt, dessen Inhaberin die Anmelderin ist.

Bei dem genannten Verfahren wurden, neben anderen zusätzlichen Besonderheiten, auf einer Platte aus elektrisch isolierendem Material Löcher zum Einstecken der Zapfen der elektronischen Teile so vorgesehen, dass diese Zapfen nach der körperlichen Befestigung bzw. Verbindung der Teile an der Halteplatte in geeigneter Weise mit Hilfe eines Führungsdrahtes, dessen Enden um die entsprechenden Zapfen der jeweils zu verbindenden Komponentenpaare gewickelt wurden, verbunden werden konnten. Das vorerwähnte Erfindungspatent enthielt weiterhin ein Werkzeug bzw. eine Vorrichtung zur Durchführung dieser Verkabelungsoperation.

Die durch die Erfindung zum selben Zweck vorgeschlagene Vorrichtung weist spezifische Strukturmerkmale auf, welche ihr eine grössere Funktionalität und bessere Betriebsleistungen verleihen.

Bei der Vorrichtung des früheren Patentes war ein länglicher
Körper vorgesehen, der in seiner Form einem Schreibstift
glich und an seinem einen Ende in einer Kabelrolle auslief,
welche bei einer Axialbewegung durch den Körper am entgegengesetzten Ende durch eine Öffnung austrat, während der Körper seitlich ein Messer aufwies, das über eine entsprechende
Steuerung betätigt wurde und dessen freies, dem schneidenden
Teil gegenüberliegendes Ende in den Körper eindrang und mit
einer Buchse verbunden wurde, deren Tätigkeit zwei Federn
unterstützten, von denen die eine das Messer in die Ruhestellung zurückholte und die andere die Bremse der Kabelrolle zur
Spannung des Drahtes über ein Zwischenstössel mit Druck beaufschlagte.

Die ausgehend von diesen allgemeinen, grundlegenden Merkmalen beschriebene Vorrichtung wurde im Hinblick auf eine Steigerung der Funktionalität und Wirksamkeit bemerkenswert verbessert. In Übereinstimmung mit einem der Erfindungsmerkmale
enthält der Körper der Vorrichtung zwei Schleifbacken, die
in der Lage sind, den Schutzüberzug des Kabels an den für den
Anschluss des Kabels an den Zapfen der Komponenten vorgesehenen Stellen zu entfernen. Die erwähnten Backen stehen mit
zwei flexiblen Platten in Verbindung, die in diametraler Stellung mit einer Lagerbuchse verbunden sind, wobei die Backen
auf der Aussenseite jeweils Anschlagstifte aufweisen, welche
so in schraubenförmigen Schlitzen auf der Innenseite des Körpers geführt werden, dass eine Axialbewegung der Lagerbuchse
ein Schliessen der Backen und damit ein Abschleifen des Kabels
zur Entfernung des Glasurüberzuges bewirkt.

In Übereinstimmung mit einem weiteren der Erfindungsmerkmale
wird an der Kabelaustrittsöffnung eine Abdichtungsbuchse aus
einem elastischen Werkstoff, z.B. aus Gummi, angeordnet, welche den Kabeldurchlauf so drosselt, dass die Buchse ein
Durchdringen des während des Abschleifens hervorgerufenen
Staubes bzw. der Späne zur Verteilerspitze verhindert und
eine einwandfreie Sauberkeit des Kabels gewährleistet, wobei die Schleifreste über seitliche Löcher im Körper auf der Höhe des wirksamen Endes der genannten Reinigungsbuchse nach aussen abgeführt werden.

Gemäss einem weiteren der Merkmale der Erfindung wird die Bremse für die Kabalzufuhrrolle über eine vom Messerantrieb unabhängige Steuerung bedient. Diese Steuerung ist mit einem Schieberohr verbunden, das seinerseits auf eine Schiebebuchse wirkt, die über eine Bremsfeder mit der Rollenbremse in Verbindung steht.

Der Messerantrieb kann zur Frontalprojektion desselben gleichzeitig auch als Antrieb für die Schleifbacken eingesetzt werden, zu welchem Zweck das hintere Messerende mit einer für die Axialverschiebung angeordneten Buchse in Verbindung gebracht und an der Lagerbuchse für die flexiblen Platten, die mit den Backen verbunden sind, eine Scheibe dazwischengelegt wird.

Durch die gesamte Struktur führt axial ein Rohr geringen Durchmessers, das als Führung für den Draht dient, welcher von der Kabelrolle aus zum Bereich der Schleifbacken, die sich verhältnismässig nahe der Öffnung oder Verteilerspitze befinden, gespannt wird.

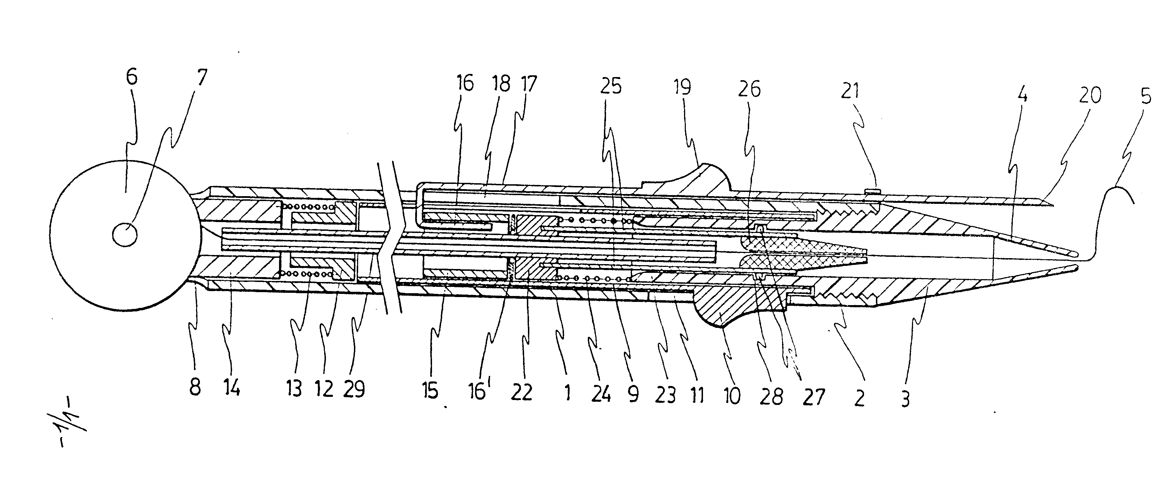

Zur Ergänzung der vorliegenden Beschreibung und im Hinblick auf ein besseres Verständnis der Erfindungsmerkmale wird dieser Patentschrift als Bestandteil derselben eine Zeichnung beigefügt, welche in ihrer einzigen Abbildung in erläuternder, doch keineswegs einschränkender Weise einen Aufriss und Querschnitt einer Vorrichtung für die von Hand durchgeführte Verkabelung von elektronischen Kreisläufen entsprechend dem Gegenstand der vorliegenden Erfindung zeigt, wobei der Querschnitt auf der Ebene der Steuerungen für den Schnitt und die Blockierung vorgenommen wurde.

Obgleich sich die Erfindung ausschliesslich auf die vorstehend dargelegten Merkmale bezieht, die auch erneut in den anliegenden Patentansprüchen aufgezeigt werden, wird die Vorrichtung allgemein beschrieben, um ein besseres Verständnis ihrer

- 4 -

0228704

Struktur und Betriebsweise zu ermöglichen.

An Hand der Abbildung ist ersichtlich, dass die vorgeschlagene
Vorrichtung aus einem zylinderförmigen, deutlich länglichen
Grundkörper 1 besteht, der leicht zu handhaben ist und an seinem einen Ende ein Innengewinde 2 aufweist, über welche er
das kegelstumpfförmige Nippel 3 aufnimmt, in das axial die Verteilerspitze 4 eingesetzt wird, über die der von der Rolle 6
zugeführte Draht 5 nach aussen tritt, wobei sich die Drehachse
7 der erwähnten Rolle zwischen zwei gegenüberliegenden Laschen 8 am entgegengesetzten Ende des Körpers 1 befindet.

Im Körper 1 wird ein Schieberohr 9 vorgesehen, das mit einer
Blockierungssteuerung 10 verbunden ist, die radial nach aussen
tritt, wobei die Möglichkeit einer Axialverschiebung über ein
schlitzförmiges Fenster 11 besteht, während das Schieberohr 9
an seinem hinteren Ende eine Schiebebuchse 12 aufnimmt, die
eine Abstufung besitzt, auf der sich eine Feder 13 abstützt,
die am anderen Ende auf eine Bremse 14 einwirkt, welche ihrerseits eine Wirkung auf die Rolle 6 ausübt, wodurch mittels
einer Rücksetzung der Steuerung 10 und mit Hilfe der Feder 13
ein Andrücken der Bremse 14 gegen die Rolle 6 erzielt wird,
was zur Notwendigkeit einer bestimmten Zugbeanspruchung des
Kabels 5 führt, damit dieses von der Rolle abgewickelt oder
aber vollständig blockiert werden kann.

In das Schieberohr 9 wird eine Buchse 15 eingesetzt, welche
in ihrem hinteren Bereich das doppelt abgewinkelte Ende 16
des Messers 17 aufnimmt, das sich ausserhalb des Körpers 1
auf einer seiner Mantellinien befindet, zu welchem Zweck der
Körper eine andere, weitgehend geschlitzte Öffnung 18 aufweist, wobei das erwähnte Messer 17 eine entsprechende
Schnittsteuerung 19 besitzt und dicht an der äusseren Schneide 20 durch eine mit dem Körper 1 verbundene Führung 21 vorschriftsmässig in Längsrichtung befestigt wird.

Die Messerbuchse 15 stützt sich über die Scheibe 16' auf einer weiteren Buchse 22 ab, die ebenfalls im Innern des Schieberohrs 9 läuft und dem Schälmechanismus entspricht. Die Buchse 22 liegt auf einem weiten Zylinderhals 23, der eine
Verlängerung des Nippels 3 im Schieberohr 9 ist, wobei zwischen dieselben eine Feder 24 gesetzt wird, welche das Messer 17 über die Buchsen 22 und 15 in die hintere bzw. Ruhestellung bringt, während die Betätigung der Messersteuerung
19 eine Längsverschiebung des Messers gegen diese Feder 24
bewirkt.

Derselbe Antrieb wird für das Schälen des Kabelüberzuges benutzt, zu welchem Zweck die Schälbuchse 22 mit zwei diametral gegenüberliegenden flexiblen Platten 25 verbunden wird,
an deren jeweiligen freien Enden Schleifbacken 26 angebracht
werden, welche sich übereinanderliegend schliessen und dadurch das Abziehen der Glasur verursachen. Um ein Schliessen
der Backen 26 zu erzielen, weisen die Platten 25 an ihren,
diesen Backen entsprechenden freien Enden an der Aussenseite
jeweils Anschlagstifte 27 auf, die in schraubenförmigen Rillen 28 an der Innenseite des Halses 23, welcher eine Verlängerung des Kopfstückes 3 darstellt, laufen. Diese Rillen bewirken nicht nur das Schliessen der Backen, sondern auch eine
Drehung der Schälvorrichtung, welche deren Wirkung erhöht und
Dank der zwischen die Buchsen 22 und 15 gelegten Scheibe 16'
einwandfrei durchführbar ist.

Zur Gewährleistung einer guten Führung des Kabels 5 entlang
der Vorrichtung ist vorgesehen, ausgehend von der Bremse 14,
über die mit dem Messer verbundene Schiebebuchse 15, über die
Scheibe 16', über die Schälbuchse 22 und zwischen den flexiblen Platten hinweg ein Kabelführungsrohr 29 geringen Durchmessers anzuordnen, welches das Kabel vom Austritt aus der
Rolle 6 bis zu den Schleifbacken 26 führt, womit dessen Unabhängigkeit von allen Mechanismen des Körpers, die - mit Ausnahme der genannten Schleifbacken-auch unabhängig vom Kabel
sein müssen , erzielt wird. Das Rohr 29 erleichtert ausserdem das Einfädeln des Kabels von der Rolle 6 bis zur Verteilerspitze 4.

Aus der Beschreibung der Struktur ergibt sich, dass durch Betätigung der Steuerung 10 die dem Kabel 5 für dessen Ablauf
von der Rolle 6 aufzuerlegende Spannung und somit die Kabelspannung zwischen den beiden Anschlusspunkten eingestellt werden kann, während es bei Betätigung der Steuerung 19 möglich
ist, einerseits das Kabel nach jeder Verkabelungsoperation
durchzuschneiden und andererseits das Kabel mit Hilfe der
Schleifbacken 26 zu schälen, soweit das Kabel einen elektrisch
isolierenden Harzüberzug aufweist, der an den Verbindungsstellen zu entfernen ist.

Ausgehend von der beschriebenen Ausführung können geringe
Änderungen eingeführt werden, wie z.B. ein Weglassen der Bremse
14 und der diese unterstützenden Feder, wobei die Schiebebuchse
12 als eine Art Gabel gestaltet wird, welche innen zwischen den
Befestigungsmittel der Rolle und der Rolle selbst gleitet und
sich fest verklemmt, wodurch die Drehbewegung derselben blockiert
wird.

Es besteht auch die Möglichkeit, den Umfang der Rollenflügel
mit einem gezahnten Rand auszustatten und das obere Ende der
Schiebebuchse 12 zweckmässigerweise entsprechend dem Inhalt
des vorangehenden Absatzes zu schleifen, damit die Zähne in
die Kerben der Rolle eingreifen und diese dadurch einwandfrei
blockieren.

Es ist weiterhin die Möglichkeit vorgesehen, koaxial zur Schälbuchse 22 eine elektromagnetische Spule aus einem leicht magnetisierbaren Material anzuordnen, welche der Kabelschälvorrichtung und damit auch den Schleifbacken 26 bei Versorgung
mit Pulsationsstrom eine Schwingungsbewegung verleiht und
auf diese Weise eine maximale Wirksamkeit derselben sicherstellt.

Man hält es nicht für notwendig, diese Beschreibung noch ausführlicher zu gestalten, damit dem Fachmann auf diesem Gebiet
die Reichweite der Erfindung und die daraus abgeleiteten Vorteile verständlich werden.

Die Materialien, Form, Grösse und Anordnung der Teile können abgeändert werden, soweit der wesentliche Sinn der Erfindung erhalten bleibt.

Die in dieser Beschreibung gemachten Angaben sind stets im weitgehenden Sinne, niemals ein Einschränkung zu betrachten.

PATENTANSPRÜCHE

1. VORRICHTUNG FÜR DIE VON HAND DURCHGEFÜHRTE VERKABELUNG ELEKTRONISCHER KREISLÄUFE in der Art der Vorrichtungen, welche aus einem länglichen Körper bestehen, die an einem ihrer Enden in einer Kabelrolle auslaufen und am anderen Ende ein Nippel mit einer Verteilerspitze aufweisen, über die das diesen Körper axial durchlaufende Kabel nach aussen tritt, und welche ausserdem ein Kabelmesser besitz-en, das sich längs auf der Aussenseite des Körpers bewegt, und zwar in Übereinstimmung mit einer der Mantellinien, und über eine entsprechende Steuerung verfügt, wobei das dem operativen Ende gegenüberliegende Endteil doppelt abgewinkelt ist, um in den Körper einzudringen und dort mit einer Buchse in Verbindung zu treten, die sich axial gegen die Spannung einer Feder verschiebt, hauptsächlich dadurch gekennzeichnet, dass sich die erwähnte Messerbuchse auf der entsprechenden Feder abstützt und eine weitere Buchse eingesetzt wird, die mit zwei flexiblen, diametral gegenüberliegenden Platten beachtlicher Länge verbunden ist , welche an ihren Enden jeweils als Schleifbacken ausgebildet werden, zwischen denen das Kabel durchläuft und deren Verschluss die Entfernung des Kabelüberzuges bewirkt, und dass weiterhin vorgesehen wurde, dass diese flexiblen Platten in Übereinstimmung mit den genannten Backen auf ihrer Aussenseite äussere Anschlagstifte enthalten, die in schraubenförmigen Rillen auf der Innenseite des Körpers, vorzugsweise auf der Innenseite des Halses als axiale Verlängerung des die Verteilerspitze tragenden Nippels, laufen, in dem dieser Körper so angeordnet wird, dass das Verschieben der Buchse, mit welcher die flexiblen Platten verbunden sind, Dank der schraubenförmigen Rillen eine Drehung der Backen bewirkt, die deren Schleifwirkung auf den Harzüberzug des Kabels erhöht, zu welchem Zweck, d.h. zur Erleichterung der Drehung der Schälvorrichtung, die entsprechende Buchse und die Messerbuchse durch eine Zwischenscheibe voneinander getrennt werden.

0228704

2. VORRICHTUNG FÜR DIE VON HAND DURCHGEFÜHRTE VERKABELUNG
ELEKTRONISCHER KREISLÄUFE, nach Anspruch 1 dadurch gekennzeichnet, dass an dem umhüllenden Körper eine zweite
Steuerung angeordnet wird, vorzugsweise in einer der
Schnittsteuerung diametral gegenüberliegenden Stellung,
die in einer weiteren, länglich geschlitzten Öffnung des
Körpers läuft, und an der ein Schieberohr beachtlicher
Länge angebracht wird, an dem die Messerbuchse und die
der Schälvorrichtung angehörenden Elemente angeordnet
sind, wobei dieses Schieberohr mit seinem hinteren Ende
auf einer Schiebebuchse aufliegt, die durch das Zwischensetzen einer Feder auf die Bremsbuchse der Rolle wirkt,
und weiterhin, wahlweise, die Möglichkeit vorgesehen ist,
dass diese Bremsbuchse - bei Entfernung der Feder und der
zweiten Buchse - direkt auf die Rolle wirkt, sei es durch
Kupplung zusätzlicher Verzahnungen der Schiebebuchse und
des Umfangs der Rollenflügel, oder aber durch Ausbildung
einer Art Gabel an der Schiebebuchse, welche zwischen die
Flügel der Rolle und deren entsprechende Halterung eingreift.

3. VORRICHTUNG FÜR DIE VON HAND DURCHGEFÜHRTE VERKABELUNG
ELEKTRONISCHER KREISLÄUFE, nach den vorstehenden Ansprüchen dadurch gekennzeichnet, dass zwischen der Bremsbuchse
am Kabelrollenauslauf und den Schleifbacken in der Nähe
des die Verteilerspitze tragenden Nippels axial ein Kabelrohr geringen Durchmessers angeordnet wird, welches das
Einfädeln der Vorrichtung erleichtert.

4. VORRICHTUNG FÜR DIE VON HAND DURCHGEFÜHRTE VERKABELUNG
ELEKTRONISCHER KREISLÄUFE, nach den vorstehenden Ansprüchen dadurch gekennzeichnet, dass die Schälbuchse, mit
welcher die flexiblen Platten, die die Schleifbacken tragen, verbunden sind, wahlweise durch eine elektromagnetische
Spule unterstützt wird, die den Schleifbacken über die flexiblen Platten eine Schwingungsbewegung verleiht und dadurch
deren Schälwirkung erhöht.

5. VORRICHTUNG FÜR DIE VON HAND DURCHGEFÜHRTE VERKABELUNG ELEKTRONISCHER KREISLÄUFE, gemäss der Beschreibung und den Ansprüchen dieser Patentschrift, welche aus sechzehn einseitig mit der Schreibmaschine beschriebenen Blättern besteht und in den anliegenden Zeichnungen dargestellt wird.

Madrid, den

I.A.

-1/1-

0228704